# EUROPEAN PATENT APPLICATION

(11) **EP 3 503 209 A1**
(43) Date of publication of application: **26.06.2019**
(21) Application number: 18186542.9
(22) Date of filing: 31.07.2018
(51) Int. Cl.: H01L 31/0224, H01L 31/05, H01L 31/068, H01L 31/18

(54) **PROCESSING METHOD FOR PHOTOVOLTAIC CELL AND STRING WELDING AND CURING DEVICE FOR PHOTOVOLTAIC CELL**

(30) Priority: 21.12.2017 CN 201711396039
(71) Applicant: Beijing Juntai Innovation Technology Co., Ltd, 100176 Beijing (CN)
(72) Inventor: Cai, Cen, Beijing, 100176 (CN); Huang, Tongyang, Beijing, 100176 (CN); Guo, Zheng, Beijing, 100176 (CN)
(74) Representative: Soria Parra, Manuel

(57) **Abstract**

The present invention provides a processing method for a photovoltaic cell and a string welding and curing device for a photovoltaic cell. The method includes step S1: plating both side surfaces of a monocrystalline silicon wafer; Step S2: forming a first electrode on one side surface of the plated monocrystalline silicon wafer;; Step S3: forming a second electrode on the other side surface of the plated monocrystalline silicon wafer, to form a cell sheet; and Step S4: string welding a plurality of cell sheets and at the same time, curing the first electrode and the second electrode, by using a string welding and curing device for a photovoltaic cell. With the processing method provided by the present invention, the electrodes on the cell sheets can be cured while the cell sheets are string welded. It can save resources, shorten the processing time of the photovoltaic cell, and improve the production efficiency.

## Description

### TECHNICAL FIELD

The present invention relates to the technical field of solar cells, in particular to a processing method for a photovoltaic cell and a string welding and curing device for a photovoltaic cell.

### BACKGROUND

With the depletion of natural resources such as petroleum and coal on the earth, development of new natural resources has become an urgent task. At present, solar energy has become the focus of development due to its advantage of cleanness.

In main aspect of the use of solar energy, sunlight radiation is converted through the solar cells into electricity, heat, and other energies that humans can utilize. High-efficiency heterojunction solar cells have become the focus of development due to their advantages of high efficiency. When preparing a heterojunction solar cell, it is necessary to firstly prepare a cell sheet. After the cell sheet is completed, multiple cell sheets are string welded into a string of cell sheets through a solder ribbon. Finally, the string of cell sheets is packaged with a back plate, a front plate and other packaging materials, and the entire heterojunction solar cell is completed.

In the above processes for preparing a heterojunction solar cell, the last process for preparing the cell sheet is generally as follows: printing a silver paste electrode, and then drying and curing the silver paste. After the cell sheets are completed, the string welding process of the cell sheets immediately follows. At present, infrared heating is required when silver paste is cured, and infrared heating is also required when the string welding is performed.

At present, the silver paste curing of the cell sheet and the string welding of the cell sheet are respectively performed with infrared heating, resulting in waste of resources, as well as prolonged processing time and reduced production efficiency.

### SUMMARY

The objective of the present invention is to provide a processing method for a photovoltaic cell and a string welding and curing device for a photovoltaic cell, to solve the above problems, save resources, shorten processing time, and increase production efficiency.

The present invention provides a processing method for a photovoltaic cell, including:
Step S1: plating both side surfaces of a monocrystalline silicon wafer;
Step S2: forming a first electrode on one side surface of the plated monocrystalline silicon wafer;
Step S3: forming a second electrode on the other side surface of the plated monocrystalline silicon wafer, to form a cell sheet; and
Step S4: string welding a plurality of cell sheets and at the same time, curing the first electrode and the second electrode, by using a string welding and curing device for a photovoltaic cell.

In the processing method for a photovoltaic cell described above, preferably, step S1 specifically includes:
Step S11: texturing and cleaning the both side surfaces of the monocrystalline silicon wafer;
Step S12: depositing a first intrinsic passivation layer and a first amorphous silicon doped layer on one side surface of the monocrystalline silicon wafer in sequence; depositing a second intrinsic passivation layer and a second amorphous silicon doped layer on the other side surface of the monocrystalline silicon wafer in sequence; and
Step S13: depositing a first transparent conductive layer on the first amorphous silicon doped layer; depositing a second transparent conductive layer on the second amorphous silicon doped layer.

In the processing method for a photovoltaic cell described above, preferably, step S2 specifically includes:
Step S21: forming a first electrode by screen printing a mixed solution of silver and resin on the first transparent conductive layer; and
Step S22: drying the first electrode.

In the processing method for a photovoltaic cell described above, preferably, step S3 specifically includes:
Step S31: performing a first screen printing of a mixed solution of silver and resin on the second transparent conductive layer, to form a base layer of the second electrode;
Step S32: drying the base layer of the second electrode;
Step S33: performing a second screen printing of a mixed solution of silver and resin on the base layer of the second electrode, to form the second electrode; and
Step S34: drying the second electrode.

In the processing method for a photovoltaic cell described above, preferably, step S4 specifically includes:
Step S41: arranging the plurality of cell sheets at intervals on a conveying device, and placing a solder ribbon between adjacent cell sheets, with one end of the solder ribbon contacting the first electrode of one cell sheet and the other end of the solder ribbon contacting the second electrode of an adjacent cell sheet at a side;
Step S42: pressing tightly the solder ribbon and the cell sheets together with a pressing pin; and
Step S43: heating, by a heating device, the solder ribbon and the electrodes of the cell sheets so that they are welded to form a string of cell sheets, and at the same time, curing the first electrode and the second electrode.

In the processing method for a photovoltaic cell described above, preferably, in step S43, the heating device includes a first heating component disposed above the conveying device and a second heating component disposed below the conveying device; and

Step S43 specifically includes: turning on the first heating component and the second heating component, to heat the solder ribbon, an upper surface and a lower surface of the cell sheet simultaneously, such that the solder ribbon, and the electrodes of the cell sheet are welded to form the plurality of cell sheets in series, and the first electrode and the second electrode are cured.

In the processing method for a photovoltaic cell described above, preferably, step S43 further includes: controlling the heating device to cure the first electrode and the second electrode of the cell sheet at a temperature between 150 and 230 degrees Celsius for 20 to 40 minutes.

In the processing method for a photovoltaic cell described above, preferably, in step S12, the first intrinsic passivation layer and the first amorphous silicon doped layer are deposited on one side surface of the monocrystalline silicon wafer in sequence, and the second intrinsic passivation layer and the second amorphous silicon doped layer are deposited on the other side surface of the monocrystalline silicon wafer in sequence, by using plasma-enhanced chemical vapor deposition or hot filament chemical vapor deposition.

In the processing method for a photovoltaic cell described above, preferably, in step S13, the first transparent conductive layer is deposited on the first amorphous silicon doped layer and the second transparent conductive layer is deposited on the second amorphous silicon doped layer, by using physical vapor deposition.

The present invention also provides a string welding and curing device for a photovoltaic cell, including:
a conveying device;
a first heating component including an infrared heater and a hot air device, wherein both the infrared heater and the hot air device are provided above a conveying surface of the conveying device, and can be raised and lowered; and
a pressing pin, wherein the pressing pin is provided above the conveying surface of the conveying device, and can be raised and lowered.

Preferably, the string welding and curing device for a photovoltaic cell described above also includes a support stand, wherein the support stand is provided above the conveying surface of the conveying device, and can be raised and lowered; and
the infrared heater, the hot air device and the pressing pin are all fixedly connected to the support stand.

Preferably, the string welding and curing device for a photovoltaic cell described above also includes an electric lifting device, wherein the electric lifting device includes a lifting plate; the lifting plate is disposed above the conveying surface of the conveying device; the lifting plate can be moved toward or away from the conveying device; and the support stand is fixed on the lifting plate.

In the string welding and curing device for a photovoltaic cell described above, preferably, the electric lifting device also includes a driving member, and a driving end of the driving member is fixedly connected to the lifting plate.

Preferably, the string welding and curing device for a photovoltaic cell described above also includes a second heating component, wherein the second heating component is disposed on the conveying device on one side of the conveying device facing away from the conveying surface.

Preferably, the string welding and curing device for a photovoltaic cell described above also includes a support platform for supporting the conveying device, wherein the support platform is disposed below the conveying device; and the second heating component is fixed on the support platform.

The present invention provides a processing method for a photovoltaic cell, including step S1: plating both side surfaces of a monocrystalline silicon wafer; Step S2: forming a first electrode on one side surface of the plated monocrystalline silicon wafer; Step S3: forming a second electrode on the other side surface of the plated monocrystalline silicon wafer, to form a cell sheet; and Step S4: string welding a plurality of cell sheets and at the same time, curing the first electrode and the second electrode, by using a string welding and curing device for a photovoltaic cell. With the processing method provided by the present invention, the electrodes on the cell sheets can be cured while the cell sheets are string welded. It can save resources, shorten the processing time of the photovoltaic cell, and improve the production efficiency.

### BRIEF DESCRIPTION OF THE DRAWINGS

Fig. 1 is a flowchart of a processing method for a photovoltaic cell according to an embodiment of the present invention;
Fig. 2 is a front view of a string welding and curing device for a photovoltaic cell according to an embodiment of the present invention;
Fig. 3 is a side perspective view of a string welding and curing device for a photovoltaic cell according to an embodiment of the present invention.

**Reference Numerals:**

| | |
|---|---|
| 10-Conveying device | 20 - Lifting plate |
| 21 - Connecting protrusion | 30 - First heating component |
| 40-Pressing pin | 50-Support stand |
| 60-Support platform | |

### DETAILED DESCRIPTION

Hereinafter, embodiments of the present invention will be described in detail. Examples of the embodiments are shown in the accompanying drawings. The same or similar reference numerals throughout the drawings denote the same or similar elements or elements having the same or similar functions. The embodiments described below with reference to the drawings are exemplary, are used to explain the present invention, and cannot be construed as limiting the present invention.

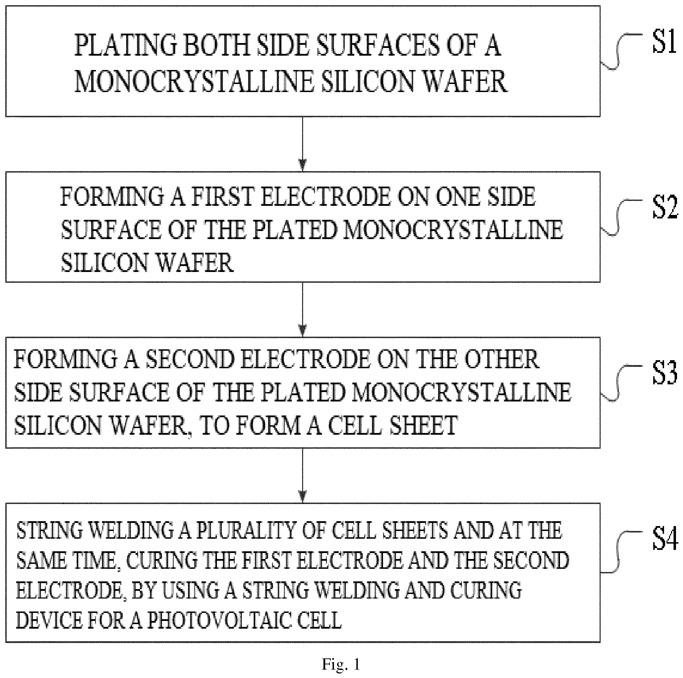

As shown in Fig. 1, the present invention provides a processing method for a photovoltaic cell, including the following steps.

In step S1, both side surfaces of a monocrystalline silicon wafer are plated. The plating specifically includes the following steps.

In Step S11, the both side surfaces of a monocrystalline silicon wafer are textured and cleaned. Texturing is to form pyramidal suede surfaces on the both side surfaces of a monocrystalline silicon wafer, and the size of the pyramid is 1 to 10 microns. Texturing can reduce reflection on the surface of the monocrystalline silicon wafer, and thereby increase the conversion rate of the solar cell sheet.

In Step S12, a first intrinsic passivation layer and a first amorphous silicon doped layer are deposited on one side surface of the monocrystalline silicon wafer in sequence; a second intrinsic passivation layer and a second amorphous silicon doped layer are deposited on the other side surface of the monocrystalline silicon wafer in sequence. Specifically, the above intrinsic passivation layers and the amorphous silicon doped layers may be deposited on the two side surfaces of the monocrystalline silicon wafer by plasma-enhanced chemical vapor deposition (PECVD) or hot filament chemical vapor deposition (HWCVD). The two intrinsic passivation layers and the two amorphous silicon doped layers are formed in the same manner, deposited in different chambers, and can be processed in the same step. Preferably, the first amorphous silicon doped layer is an N-type amorphous silicon base layer, the second amorphous silicon doped layer is a P-type amorphous silicon base layer; and the first intrinsic passivation layer and the second intrinsic passivation layer are both amorphous silicon based intrinsic layers.

In Step S13, a first transparent conductive layer is deposited on the first amorphous silicon doped layer; a second transparent conductive layer is deposited on the second amorphous silicon doped layer. Specifically, the first transparent conductive layer and the second transparent conductive layer may be prepared by physical vapor deposition (PVD), or may be prepared by remote plasma coating (RPD). Preferably, the above first transparent conductive layer and the second transparent conductive layer are both TCO glass layers.

In Step S2, a first electrode is formed on one side surface of the plated monocrystalline silicon wafer. Specifically, the first electrode is formed on the first transparent conductive layer. Preferably, a plurality of first fine gate lines and a first main gate line may be printed on the first transparent conductive layer by screen printing. The first fine gate lines and the first main gate line constitute the first electrode. It should be understood by those skilled in the art that, since the electrodes of the cell sheet are mostly made of mixed solution of silver paste and resin, the first electrode has to be dried after the first electrode is formed. Specifically, a hot air blower can be used for the drying.

In Step S3, a second electrode is formed on the other side surface of the plated monocrystalline silicon wafer, to form a cell sheet. Specifically, a second electrode is formed on the second transparent conductive layer to form a cell sheet. Further, both the first electrode and the second electrode are both made of silver paste and resin. The process of forming the second electrode specifically includes performing a first printing on the second transparent conductive layer by screen printing to form a base layer of the second electrode; drying the base layer of the second electrode; and performing a second printing on the base layer of the second electrode by screen printing to form the second electrode; and finally, drying the second electrode. Specifically, a hot air blower can be used for the drying.

More specifically, a plurality of second fine gate lines may be printed on the second transparent conductive layer by screen printing to form the base layer of the second electrode. A plurality of third fine gate lines and a second main gate line are printed on the base layer of the second electrode by screen printing. The third fine gate lines cover the second fine gate lines. Consequently, the second fine gate lines, the third fine gate lines and the second main gate line form the second electrode.

Since the processed cell sheet is a bifacially-generated battery, it is necessary to print the electrodes on both side surfaces of a monocrystalline silicon wafer. In practical applications, the silver content of the electrode on the side surface having the larger light-receiving area can be increased in order to increase the electrical conductivity. Therefore, the second electrode is printed twice. The second fine gate line of the base layer of the second electrode formed in the first printing has a thickness equal to the thickness of the first fine gate line of the first electrode. After the twice printings, a total thickness of the second fine gate line and the third fine gate line of the second electrode is twice of the thickness of the first fine gate line of the first electrode, thus greatly improving the electrical conductivity.

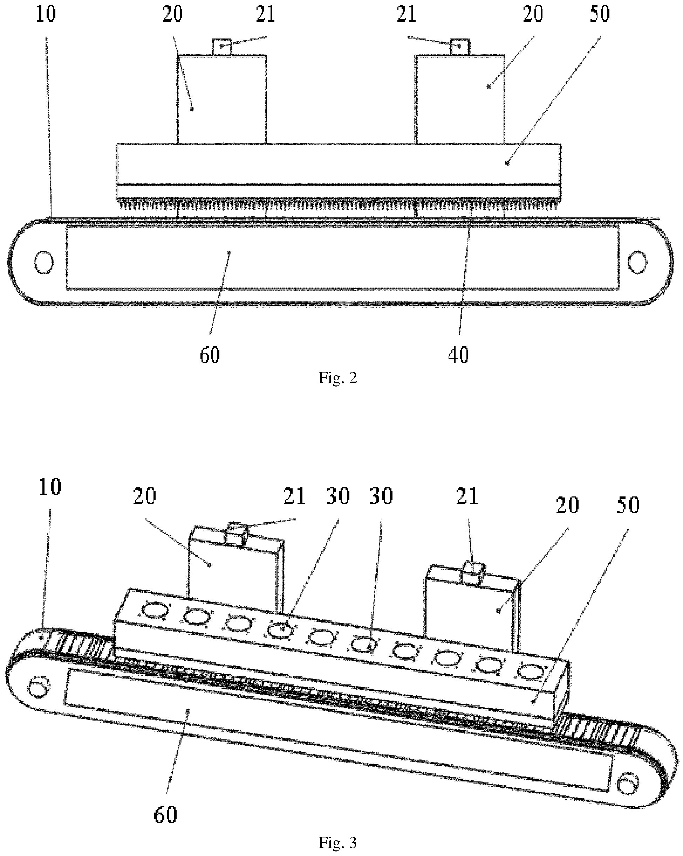

In Step S4, a plurality of cell sheets are string welded and at the same time, the first electrode and the second electrode are cured, by using a string welding and curing device for a photovoltaic cell. The following description is given in connection with the string welding and curing device for a photovoltaic cell as shown in Figs. 2 and 3.

The step S4 specifically includes step S41, in which the plurality of cell sheets are arranged at intervals on a conveying device 10, and a solder ribbon is placed between adjacent cell sheets, with both ends of the solder ribbon respectively connected to the opposite electrodes of the adjacent cell sheets. It should be understood by those skilled in the art that, when the solar cell sheets are arranged, appropriate distances should be maintained, and the number of the arranged sheets may be adjusted according to actual situation. For example, 2 to 12 cell sheets may be arranged on the conveying device 10, and a solder ribbon is disposed between adjacent cell sheets, with one end of the solder ribbon connected to the first electrode of the first cell sheet, and the other end of the solder ribbon connected to the second electrode of the second cell sheet adjacent to the first cell sheet.

In Step S42, the solder ribbon and the cell sheets are pressed together with a pressing pin 40. Specifically, when the solder ribbon and the cell sheets are placed, the pressing pin 40 is moved away from the conveying device 10, and after the placement is completed, the pressure pin 40 is moved to the connection where the solder ribbon and the cell sheets are pressed together, and the solder ribbon and the cell sheets are pressed tightly and fixed.

In Step S43, heated by a heating device, the solder ribbon and the electrodes of the cell sheets are welded to form a string of cell sheets, and at the same time, the first electrode and the second electrode are cured. After the solder ribbon and the cell sheets are pressed tightly with the pressing pin 40, the heating device is started, to heat the cell sheets and the solder ribbon at a temperature of 150-230°C for 20 - 40 minutes. For example, the cell sheets and the solder ribbon is heated at a temperature of 150°C for 40 minutes or at a temperature of 230°C for 20 minutes. At this time, the solder ribbon and the electrodes of the cell sheets are welded. Therefore, the plurality of cell sheets are successfully connected in series. At the same time, the first electrode and the second electrode on the cell sheet are heated to be cured, thus finishing the process. Since the welding requires a short time, after the pressing pin presses tightly against the solder ribbon and the cell sheets to assist the welding, the pressing pin may be moved upwards away from the solder ribbon and the cell sheets. At this time, the heating device heats the cell sheets and the solder ribbon at a temperature of 150-230°C for 20 - 40 minutes, mainly in order to cure the first electrode and the second electrode on the cell sheet.

Specifically, in Step S43, the heating device includes a first heating component 30 disposed above the conveying device 10 and a second heating component disposed below the conveying device 10. After the pressing pin 40 presses tightly against the solder ribbon and the cell sheets, the first heating component 30 and the second heating component are turned on, such that the solder ribbon, the upper surface and the lower surface of the cell sheet are heated simultaneously, and at the same time of the string welding, the first electrode and the second electrode are cured. The above first heating component 30 includes an infrared heater and a hot air device, and the second heating component may be a heater of resistance heating sheet.

With the processing method provided by the embodiment of the present invention, the processing steps of curing the electrodes when processing the cell sheets can be eliminated. Instead, the electrodes on the cell sheets are cured while the cell sheets are string welded, thereby saving resources, shortening the processing time for the photovoltaic cell, and improving production efficiency. It should be understood that after the string welding is completed, there is a conventional packaging process.

As shown in Fig. 2 and Fig. 3, an embodiment of the present invention further provides a string welding and curing device for a photovoltaic cell, which includes a conveying device 10, a first heating component 30, and a pressing pin 40.

The first heating component 30 includes an infrared heater and a hot air device. The infrared heater and the hot air device are provided above the conveying surface of the conveying device 10, and can be raised and lowered. The pressing pin 40 is provided above the conveying surface of the conveying device 10, and can be raised and lowered. Preferably, the above-mentioned conveying device 10 is a conveyor belt.

During processing, a plurality of cell sheets are arranged at intervals on the conveying device 10, and the solder ribbon is placed between adjacent cell sheets, with both ends of the solder ribbon respectively connected to the opposite electrodes of the adjacent cell sheets. It should be understood by those skilled in the art that, when the solar cell sheets are arranged, appropriate distances should be maintained, and the number of the arranged sheets may be adjusted according to actual situation. For example, 2 to 12 cell sheets may be arranged on the conveying device 10, and a solder ribbon is disposed between adjacent cell sheets, with one end of the solder ribbon connected to the second electrode of a first cell sheet, and the other end of the solder ribbon connected to the first electrode of a second cell sheet adjacent to the first cell sheet.

Then, the pressing pin 40 and the first heating component 30 are moved downwards approaching the conveying surface of the conveying device 10, such that the pressing pin 40 presses the solder ribbon and the cell sheets tightly to avoid the movement of the cell sheets and the solder ribbon during the subsequent welding process, which might result in defective welding. Specifically, when the cell sheets and the solder ribbon are placed, the pressing pin 40 is moved away from the conveying device 10. After the placement is completed, the pressing pin 40 is moved to a position of the cell sheets and the solder ribbon which does not require welding for pressing tightly the solder ribbon and the cell sheets together.

Next, after the press pin 40 presses tightly the solder ribbon and the cell sheets, the infrared heater and the hot air device are turned on, such that during the string welding, the first electrode and the second electrode of the cell sheet are cured.

In the string welding and curing device for a photovoltaic cell according to the embodiment of the present invention, the solder ribbon and the cell sheets are pressed together by the pressing pin 40, and then by using the first heating component 30, the string welding of the cell sheets and the solder ribbon is performed, and the first electrode of the cell sheet and the second electrode of the cell sheet are cured. It can allow string welding and curing to be simultaneously performed. It can save resources, shorten the processing time of the photovoltaic cell, and improve production efficiency.

When performing string welding and curing, the infrared heater performs a method of concentrated spot heating, and the hot air device blows out hot air to perform full heating of all the cell sheets. The infrared heater and the hot air device are mutually assisted to efficiently and reliably achieve welding and curing.

Specifically, the string welding and curing device for a photovoltaic cell provided by the embodiment of the present invention also includes an electric lifting device. The electric lifting device includes a lifting plate 20. The lifting plate 20 is disposed above the conveying surface of the conveying device 10. The lifting plate 20 can be moved toward or away from the conveying device 10. The first heating component 30 and the pressing pin 40 are fixedly connected with the lifting plate 20.

Further, the string welding and curing device for a photovoltaic cell provided by the embodiment of the present invention also includes a second heating component (not shown in the drawings). The second heating component is disposed on a side of the delivery device 10 away from the conveying surface. Preferably, the second heating component may be a resistance heating sheet and the number thereof is multiple. That is, the first heating component 30 is disposed above the conveying device 10, and the second heating component is disposed below the conveying device 10, such that both the upper and lower sides of the cell sheet and the solder ribbon can be heated.

In specific application, the electric lifting device is turned on such that the lifting plate 20 drives the pressing pin 40 and the first heating component 30 to move upward away from the conveying surface of the conveying device 10. Then the plurality of cell sheets are arranged at intervals on the conveying device 10, and the solder ribbon is placed between adjacent cell sheets, with both ends of the solder ribbon respectively connected to the opposite electrodes of the adjacent cell sheets.

Then, the electric lifting device is operated to move the lifting plate 20 downwards to drive the pressing pin 40 and the first heating component 30 to move downwards approaching the conveying surface of the conveying device 10, such that the pressing pin 40 is moved to a position of the cell sheets and the solder ribbon which does not require welding for pressing them together.

Further, the number of the above-mentioned electric lifting devices is two. With two electric lifting devices, it can increase the smoothness of the upward and downward movements of the pressure pin 40 and the first heating component 30. It can also improve the fixing reliability, and increase the operating safety factor.

Next, after the pressing pin 40 presses tightly the solder ribbon and the cell sheets, the first heating component 30 and the second heating component are turned on, such that the solder ribbon, the upper surface of the cell sheet and the lower surface of the cell sheet are simultaneously heated, and while the string welding is performed, the second electrode and the first electrode of the cell sheet are cured. Further, the string welding and curing device for a photovoltaic cell according to an embodiment of the present invention also includes a support stand 50. The support stand 50 is fixedly connected to the two lifting plates 20. The infrared heater, the hot air device and the pressing pin are all fixed on the support stand 50. The infrared heater may specifically be an infrared lamp. The heat emitting surface of the infrared lamp faces the conveying surface of the conveying device. The hot air device may be a fan blowing hot air toward the conveying surface of the conveying device. The pressing pin 40 is fixed on the underside of the support stand 50, and is close to the side of the conveying device 10. Referring to Fig. 3, it can be seen that the support stand 50 is in the form of a cuboid block on which 10 infrared lamps are mounted. When the lifting plate 20 is moved downwards, the pressing pin 40 firstly presses against the cell sheets and the solder ribbon.

More specifically, the lifting plate 20 described above is a rectangular plate, and one side of the support stand 50 is fixedly connected to one side of the bottom of the rectangular plate. A connecting protrusion 21 is provided at one end of the lifting plate 20 away from the support stand 50.

The electric lifting device also includes a driving member having a driving end fixedly connected to the lifting plate 20. Specifically, the driving member is an air cylinder, and the connecting rod of the air cylinder is fixedly connected to the connecting protrusion 21 on the lifting plate 20 so as to control the rising and lowering of the lifting plate 20 to drive the pressing pin 40 and the first heating component 30 to move up and down.

Further, the string welding and curing device for a photovoltaic cell provided by the embodiment of the present invention also includes a support platform 60 for supporting the conveying device 10. The support platform 60 is disposed below the conveying device 10, and the second heating component is fixed on the support platform 60 on one side of the support platform 60 close to the conveying device 10. The support platform 60 is configured to support the conveying device 10 such that the conveying surface of the conveying device 10 is kept stable during operation, to avoid moving of the cell sheets and the solder ribbon which results in failure of string welding.

The structure, features, and effects of the present invention have been described in detail with reference to the embodiments shown in the drawings. The above are merely preferred embodiments of the present invention, but the present invention does not limit the scope of implementation as shown in the drawings. Any equivalent embodiment altered or modified according to the concept of the present invention without go beyond the scope covered by the description and the drawings, should fall within the protection scope of the present invention.

## Claims

1. A processing method for a photovoltaic cell, comprising:
Step S1: plating both side surfaces of a monocrystalline silicon wafer;
Step S2: forming a first electrode on one side surface of the plated monocrystalline silicon wafer;
Step S3: forming a second electrode on the other side surface of the plated monocrystalline silicon wafer, to form a cell sheet; and
Step S4: string welding a plurality of cell sheets and at the same time, curing the first electrode and the second electrode, by using a string welding and curing device for a photovoltaic cell.

2. The processing method for a photovoltaic cell according to claim 1, wherein step S1 specifically comprises:
Step S11: texturing and cleaning the both side surfaces of the monocrystalline silicon wafer;
Step S12: depositing a first intrinsic passivation layer and a first amorphous silicon doped layer on one side surface of the monocrystalline silicon wafer in sequence; depositing a second intrinsic passivation layer and a second amorphous silicon doped layer on the other side surface of the monocrystalline silicon wafer in sequence; and
Step S13: depositing a first transparent conductive layer on the first amorphous silicon doped layer; depositing a second transparent conductive layer on the second amorphous silicon doped layer.

3. The processing method for a photovoltaic cell according to claim 1 or 2, wherein step S2 specifically comprises:
Step S21: forming a first electrode by screen printing a mixed solution of silver and resin on the first transparent conductive layer; and
Step S22: drying the first electrode.

4. The processing method for a photovoltaic cell according to one of the preceding claims, wherein step S3 specifically comprises:
Step S31: performing a first screen printing of a mixed solution of silver and resin on the second transparent conductive layer, to form a base layer of the second electrode;
Step S32: drying the base layer of the second electrode;
Step S33: performing a second screen printing of a mixed solution of silver and resin on the base layer of the second electrode, to form the second electrode; and
Step S34: drying the second electrode.

5. The processing method for a photovoltaic cell according to one of the preceding claims, wherein step S4 specifically comprises:
Step S41: arranging the plurality of cell sheets at intervals on a conveying device, and placing a solder ribbon between adjacent cell sheets, with one end of the solder ribbon contacting the first electrode of one cell sheet and the other end of the solder ribbon contacting the second electrode of an adjacent cell sheet at a side;
Step S42: pressing tightly the solder ribbon and the cell sheets together with a pressing pin; and
Step S43: heating, by a heating device, the solder ribbon and the electrodes of the cell sheets so that the solder ribbon and the electrodes of the cell sheets are welded to form a string of cell sheets, and at the same time, curing the first electrode and the second electrode.

6. The processing method for a photovoltaic cell according to claim 5, wherein in step S43, the heating device comprises a first heating component disposed above the conveying device and a second heating component disposed below the conveying device; and
Step S43 specifically comprises: turning on the first heating component and the second heating component, to heat the solder ribbon, an upper surface and a lower surface of the cell sheet simultaneously, such that the solder ribbon, and the electrodes of the cell sheet are welded to form the plurality of cell sheets in series, and the first electrode and the second electrode are cured.

7. The processing method for a photovoltaic cell according to claim 5 or 6, wherein step S43 further comprises: controlling the heating device to cure the first electrode and the second electrode of the cell sheet at a temperature between 150 and 230 degrees Celsius for 20 to 40 minutes.

8. The processing method for a photovoltaic cell according to any of claims 2 to 7, wherein in step S12, the first intrinsic passivation layer and the first amorphous silicon doped layer are deposited on one side surface of the monocrystalline silicon wafer in sequence, and the second intrinsic passivation layer and the second amorphous silicon doped layer are deposited on the other side surface of the monocrystalline silicon wafer in sequence, by using plasma-enhanced chemical vapor deposition or hot filament chemical vapor deposition.

9. The processing method for a photovoltaic cell according to any of claims 2 to 8, wherein in step S13, the first transparent conductive layer is deposited on the first amorphous silicon doped layer and the second transparent conductive layer is deposited on the second amorphous silicon doped layer, by using physical vapor deposition.

10. A string welding and curing device for a photovoltaic cell, comprising:
a conveying device (10);
a first heating component (30) comprising an infrared heater and a hot air device, wherein both the infrared heater and the hot air device are provided above a conveying surface of the conveying device (10), and can be raised and lowered; and
a pressing pin (40), wherein the pressing pin (40) is provided above the conveying surface of the conveying device (10), and can be raised and lowered.

11. The string welding and curing device for a photovoltaic cell according to claim 10, further comprising a support stand (50), wherein the support stand (50) is provided above the conveying surface of the conveying device (10), and can be raised and lowered; and
the infrared heater, the hot air device and the pressing pin (40) are all fixedly connected to the support stand (50).

12. The string welding and curing device for a photovoltaic cell according to claim 11, further comprising an electric lifting device, wherein the electric lifting device comprises a lifting plate (20); the lifting plate (20) is disposed above the conveying surface of the conveying device (10); the lifting plate (20) can be moved toward or away from the conveying device (10); and the support stand (50) is fixed on the lifting plate (20).

13. The string welding and curing device for a photovoltaic cell according to claim 12, wherein the electric lifting device further comprises a driving member, and a driving end of the driving member is fixedly connected to the lifting plate (20).

14. The string welding and curing device for a photovoltaic cell according to any one of claims 10 to 13, further comprising a second heating component, wherein the second heating component is disposed on the conveying device (10) on one side of the conveying device (10) facing away from the conveying surface.

15. The string welding and curing device for a photovoltaic cell according to claim 14, further comprising a support platform (60) for supporting the conveying device (10), wherein the support platform (60) is disposed below the conveying device (10); and the second heating component is fixed on the support platform (60).
